# EUROPÄISCHE PATENTSCHRIFT

(11) **EP 1 075 663 B1**
(45) Veröffentlichungstag und Bekanntmachung des Hinweises auf die Patenterteilung: **27.07.2005**
(21) Anmeldenummer: 99924826.3
(22) Anmeldetag: 27.04.1999
(51) Int. Cl.: G01R 31/316, G06F 11/267, G06F 11/27

(54) **VERFAHREN ZUM TESTEN EINER INTEGRIERTEN SCHALTUNGSANORDNUNG UND INTEGRIERTE SCHALTUNGSANORDNUNG HIERFÜR**
METHOD FOR TESTING AN INTEGRATED CIRCUIT AND CORRESPONDING INTEGRATED CIRCUIT
PROCEDE POUR TESTER UN CIRCUIT INTEGRE ET CIRCUIT INTEGRE APPROPRIE

(30) Priorität: 30.04.1998 DE 19819264
(43) Veröffentlichungstag der Anmeldung: 14.02.2001
(73) Patentinhaber: Micronas GmbH, 79108 Freiburg (DE)
(72) Erfinder: HUMMEL, Ulrich, Helmut, D-79331 Teningen (DE); BRADFORD, Jonathan, D-79111 Freiburg (DE)
(74) Vertreter: Patentanwälte Westphal, Mussgnug & Partner
(86) Internationale Anmeldenummer: PCT/EP1999/002821
(87) Internationale Veröffentlichungsnummer: WO 1999/057569

(56) Entgegenhaltungen:
- EP-A- 0 318 140
- US-A- 4 670 877
- PATENT ABSTRACTS OF JAPAN vol. 096, no. 008, 30. August 1996 (1996-08-30) & JP 08 105947 A (CANON INC), 23. April 1996 (1996-04-23)

## Beschreibung

Die Erfindung betrifft ein Verfahren zum Testen einer integrierten Schaltungsanordnung gemäß den Merkmalen des Oberbegriffs des Anspruchs 1 sowie eine integrierte Schaltungsanordnung hierfür.

Ein solches Verfahren bzw. eine solche integrierte Schaltungsanordnung ist z.B. aus US 4,670,877 bekannt.

Die Qualitätskontrolle von elektrischen Bauteilen und die Prozesskontrolle von Fertigungsmaschinen bei der Herstellung von integrierten Schaltkreisen ist von höchster Wichtigkeit, um sicherzustellen, dass die vom Hersteller ausgelieferten Bauteile den Kundenanforderungen genügen. Zu einer vernünftigen Qualitätskontrolle der elektrischen Bauteile gehört neben einem Testen der elektrischen Eigenschaften des Bauteils, und hier insbesondere der Geschwindigkeitszugriffszeiten bei Speicherbausteinen, auch die Überprüfung von äußerlich erkennbaren Defekten des Bauteils. Mittlerweile ist es üblich, das Testen von elektrischen Eigenschaften der Bauteile in geeigneten Testeinrichtungen am Ende der Fertigungslinie vollautomatisch durchzuführen.

Bei der Fertigung von elektrischen Bauteilen ist es naturbedingt nicht möglich, eine 100 %ige Fehlerfreiheit der elektrischen Bauteile zu gewährleisten. Es kommt vielmehr vor, dass einzelne elektrische Bauteile am Ende der Fertigungslinie aus irgendwelchen Gründen defekt sind. Es ist deshalb notwendig, nach dem Fertigungsprozess durch geeignete Verfahren die Fehlerfreiheit dieses Bauteils nachzuweisen.

Lösungsmöglichkeiten hierfür bestehen darin, analoge Kenngrößen des gefertigten elektrischen Bauteiles zu messen. Es ist auch möglich, an die Anschlussklemmen der integrierten Schaltungsanordnung bzw. des elektrischen Bauteils digitale Prüfmuster anzulegen und die Bauteilereaktionen auszuwerten.

Bei der Messung von analogen Kenngrößen ist problematisch, dass dies verhältnismäßig zeitaufwendig ist, wenn die digitale Signalverarbeitungseinheit innerhalb der integrierten Schaltungsanordnung geprüft werden soll. Bei einstellbaren Bauelementen sind sehr viele Messungen mit unterschiedlichen Einstellungen erforderlich. Hat ein elektrisches Bauteil tatsächlich einen Fehler, so ist es mit der Messung der analogen Kenngrößen nur sehr schwer möglich, den Fehler auch zu lokalisieren.

Bei der Möglichkeit, digitale Prüfmuster an das elektrische Bauteil anzulegen und die Bauteilereaktion auszuwerten, besteht das Problem, dass herkömmliche Testeinrichtungen, sogenannte ASIC-Tester, synchron zum elektrischen Bauteil arbeiten. Ein auf der integrierten Schaltungsanordnung, die getestet werden soll, integrierter Oszillator muss deshalb ausgeschaltet oder deaktiviert werden. Der Testtakt wird nämlich an eine Klemme der integrierten Schaltungsanordnung angelegt.

Der Erfindung liegt deshalb die Aufgabe zugrunde, ein Verfahren zum Testen einer integrierten Schaltungsanordnung anzugeben, das sehr schnell ein zuverlässiges Testergebnis liefert, ob die zu testende integrierte Schaltungsanordnung defekt ist oder nicht. Ein weiteres Ziel der Erfindung besteht darin, eine integrierte Schaltungsanordnung für ein solches Testverfahren anzugeben.

Diese Aufgabe wird für das Verfahren durch die Merkmale des Anspruchs 1 und für die integrierte Schaltungsanordnung durch die Merkmale des Anspruchs 5 gelöst.

Weiterbildungen der Erfindung sind Gegenstand der hierauf zurückbezogenen Unteransprüche.

Das erfindungsgemäße Verfahren besteht also im Wesentlichen darin, dass im Testmodus ein Pseudozufallsgenerator, innerhalb der integrierten Schaltungsanordnung eine Vielzahl von digitalen Testwerten zur Verfügung stellt. Diese Testwerte werden nacheinander jeweils einer digitalen Signalverarbeitungseinrichtung zugeführt und dort verarbeitet. Die verarbeiteten Werte werden dann einem Prüfsummenrechenwerk, das vorzugsweise eine Polynomberechnung durchführt, zugeführt, wobei das Prüfsummenrechenwerk die einzelnen Rechenergebnisse aufaddiert. Die so ermittelte Prüfsumme wird als Kriterium für die Fehlerfreiheit der integrierten Schaltungsanordnung herangezogen. Weicht also die Prüfsumme von dem vorgegebenen Prüfsummenwert ab, ist dies ein Zeichen, dass die digitale Signalverarbeitungseinrichtung in der integrierten Schaltungsanordnung defekt ist.

Der Ablauf des Testmodus stellt sich im Wesentlichen folgendermaßen dar:

Zunächst wird durch ein an die integrierte Schaltungsanordnung anzulegendes Startkommando eine im Inneren der integrierten Schaltungsanordnung angeordnete Umschalteinrichtung so gesetzt, dass diese die digitale Signalverarbeitungseinheit mit dem Pseudozufallsgenerator verbindet. Dann wird die digitale Signalverarbeitungseinheit zurückgesetzt und der Pseudozufallsgenerator gestartet. Zusätzlich wird zuvor auch noch das Prüfsummenrechenwerk vorzugsweise auf 0 zurückgesetzt. Die einzelnen, vom Signalgenerator gelieferten digitalen Werte werden in der digitalen Signalverarbeitungseinheit verarbeitet und das verarbeitete digitale Signal dem Prüfsummenrechenwerk zugeführt. Dies erfolgt für jedes am Ausgang des Pseudozufallsgenerator anstehende Signal. Nach einer vorgegebenen Anzahl von Ausgangswerten des Pseudozufallsgenerators wird dieser angehalten und schließlich eine Prüfsumme am Ausgang des Prüfsummenrechenwerkes zur Verfügung gestellt. Dieser Prüfsummenwert wird über eine Interface-Einheit einer Ausgangsklemme der integrierten Schaltungsanordnung zugeführt und dort abgefragt. Die Abfrage erfolgt hierbei vorzugsweise über einen mit einem Steuerrechner oder Testautomat verbundenen Protokollgenerator. Schließlich wird die Umschalteinrichtung wieder in ihren Normalbetrieb zurückgeschaltet.

Im Normalbetrieb ist ein analoger Schaltungsteil, der beispielsweise einen Sensor, insbesondere einen Hall-Sensor enthalten kann, mit der digitalen Signalverarbeitungseinheit in Verbindung.

Die Vorteile dieses Verfahrens bestehen in den verhältnismäßig kurzen Meßzeiten, die erforderlich sind, um festzustellen, ob die integrierte Schaltungsanordnung defekt ist oder nicht. Die integrierte Schaltungsanordnung selbst muss lediglich um wenige, zusätzliche Hardware-Komponenten, nämlich die Umschalteinrichtung, dem Pseudozufallsgenerator und das Prüfsummenrechenwerk sowie die Ablaufsteuerung ergänzt werden.

Werden die ohnehin vorhandenen Klemmen der integrierten Schaltungsanordnung als Signaleingangs- und Signalausgangsklemmen für den Testmodus herangezogen, hat dies den Vorteil, dass keine zusätzlichen Klemmen für den Testmodus bereitgestellt werden müssen. Die Zuverlässigkeit der integrierten Schaltungsanordnung ist damit im Vergleich zu anderen Schaltungsanordnungen mit mehreren Anschlussklemmen deutlich erhöht.

Das erfindungsgemäße Verfahren und die zugehörende integrierte Schaltungsanordnung werden nachfolgend im Zusammenhang mit einem Ausführungsbeispiel anhand von Figuren näher erläutert. Es zeigen:
- Fig. 1: ein Blockschaltbild einer erfindungsgemäßen integrierten Schaltungsanordnung, die über einen Protokollgenerator an einen Steuerrechner bzw. Testautomat angeschlossen ist, und
- Fig. 2: ein Funktionsablaufdiagramm für einen Testmodus der integrierten Schaltungsanordnung von Figur 1.

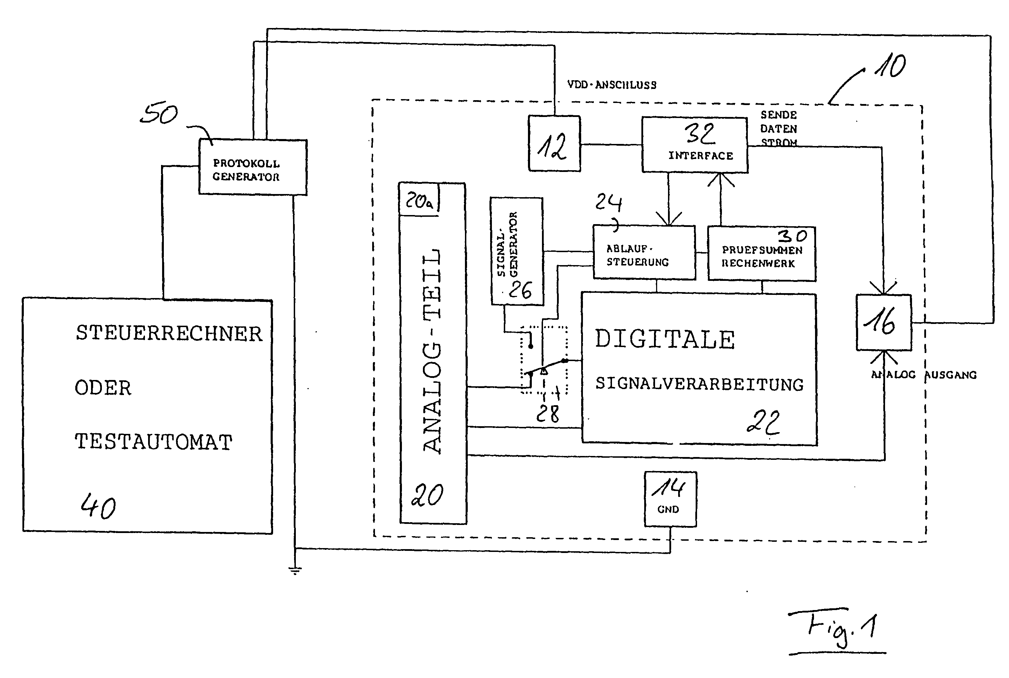

In Figur 1 ist das Blockschaltbild einer integrierten Schaltungsanordnung 10 dargestellt. Die integrierte Schaltungsanordnung 10 verfügt über drei Klemmen, nämlich einen Versorgungsspannungsanschluss 12, einen Bezugspotentialanschluss 14 und eine analoge Ausgangsklemme 16. Die integrierte Schaltungsanordnung 10 verfügt des Weiteren über einen analogen Schaltungsteil 20, welcher beispielsweise einen Sensor, insbesondere einen Hall-Sensor 20a aufweisen kann. Darüber hinaus ist eine digitale Signalverarbeitungseinheit 22 vorgesehen, die mit dem analogen Schaltungsteil 20 in Verbindung steht. Der analoge Schaltungsteil 20 steht auch mit der Ausgangsklemme 16 in Verbindung.

Wichtiger Bestandteil der integrierten Schaltungsanordnung 10 ist eine Umschalteinrichtung 28, die von einer Ablaufsteuerungseinheit 24 steuerbar ist. Die Umschalteinrichtung 28 verbindet den analogen Schaltungsteil 20 mit der digitalen Signalverarbeitungseinheit 22 oder schaltet wahlweise anstelle des analogen Schaltungsteils 20 einen Pseudozufallsgenerator 26 an den Eingang der digitalen Signalverarbeitungseinheit 22. Die Ablaufsteuerungseinrichtung 24 ist hierfür mit der digitalen Signalverarbeitungseinheit 22 in Verbindung.

Ebenfalls ist die Ablaufsteuerungseinrichtung 24 mit einer Interface-Einheit 32 in Kontakt. Diese Interface-Einheit 32 ist zwischen die Versorgungsspannungsklemme 12 und die analoge Ausgangsklemme 16 geschaltet und stellt der Ablaufsteuerung 24 Eingangssignale zur Verfügung. Schließlich verfügt die integrierte Schaltungsanordnung 10 noch über ein Prüfsummenrechenwerk 30, dem von der digitalen Signalverarbeitungseinheit 22 verarbeitete digitale Signale zugeführt werden und welche aus diesen Werten eine Prüfsumme berechnet. Diese Prüfsumme gelangt über die Interface-Einheit 32 an die analoge Ausgangsklemme 16.

Die integrierte Schaltungsanordnung 10 ist über einen Protokollgenerator 50 an einen Steuerrechner oder Testautomat 40 angeschlossen. Hierfür steht der Steuerrechner oder Testautomat 40 mit dem Protokollgenerator 50 in Verbindung, welcher mit einer Leitung an die Versorgungsspannungsklemme 12 und mit einer anderen Leitung an die analoge Ausgangsklemme 16 geschaltet ist. Zusätzlich ist der Protokollgenerator 50 noch an Bezugspotential gelegt. Ebenfalls an Bezugspotential gelegt ist die Bezugspotentialklemme 14 der integrierten Schaltungsanordnung 10.

Der Protokollgenerator 50 erzeugt einen Datenstrom zur integrierten Schaltungsanordnung 10. Dieser Datenstrom dient unter anderem zum Initiieren eines Testmodus der integrierten Schaltungsanordnung 10. Der an der analogen Ausgangsklemme 16 anstehende Datenstrom gelangt ebenfalls an den Protokollgenerator 50. Der Protokollgenerator 50 demoduliert diesen Datenstrom.

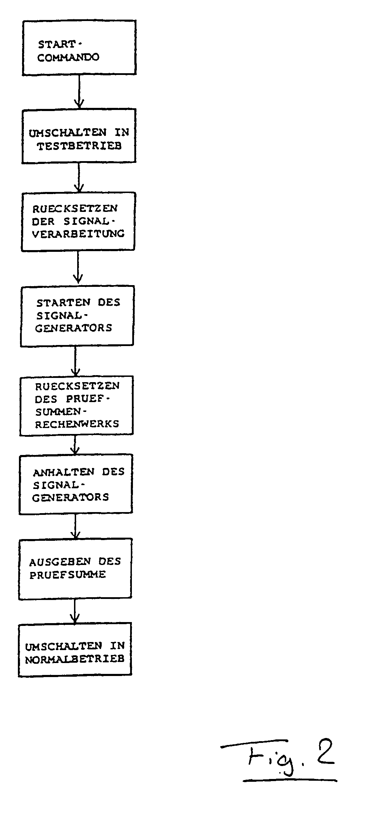

Die Funktionsweise der in Figur 1 dargestellten Schaltungsanordnung wird im Zusammenhang mit dem Funktionsablaufdiagramm von Figur 2 näher erläutert. Zunächst wird über den Steuerrechner oder Testautomat 40 dem Protokollgenerator 50 mitgeteilt, dass ein Testmodus eingeleitet werden soll. Der Protokollgenerator 50 generiert ein hierfür geeignetes Startkommando, das über die Versorgungsspannungsklemme 12 und die Interface-Einheit 32 der Ablaufsteuerung 24 der integrierten Schaltungsanordnung 10 zugeführt wird. Die Ablaufsteuerungseinrichtung 24 schaltet nach der Detektion dieses Startkommandos die Umschalteinrichtung 28 von ihrer "Normalstellung", wie diese in Figur 1 dargestellt ist, in die "Testmodusstellung" um.

In der "Testmodusstellung" verbindet die Umschalteinrichtung 28 den Pseudozufallsgenerator 26 mit dem Eingang der digitalen Signalverarbeitungseinrichtung 22. Zugleich setzt die Ablaufsteuerungseinrichtung 24 den Pseudozufallsgenerator 26, die digitale Signalverarbeitungseinrichtung 22 und das Prüfsummenrechenwerk 30 zurück. Der Pseudozufallsgenerator 26 erzeugt daraufhin eine Vielzahl von digitalen Signalwerten, die nacheinander der digitalen Signalverarbeitungseinrichtung 22 zugeführt und von dieser verarbeitet werden. Zu jedem vom Pseudozufallsgenerator 26 eingehenden digitalen Wert erzeugt die digitale Signalverarbeitungseinrichtung 22 einen zugehörenden Ausgangswert. Im Prüfsummenrechenwerk 30 wird für jeden von der digitalen Signalverarbeitungseinrichtung 22 erarbeiteten Ausgangswert eine Polynomberechnung durchgeführt und das Ergebnis der Polynomberechnung einer Addierstufe zugeführt. Die Addierstufe summiert die Vielzahl der der Polynomberechnung unterzogenen Werte und bildet hieraus einen einzigen Prüfsummenwert. Dieser Prüfsummenwert am Ausgang des Prüfsummenrechenwerkes 30 wird über die Interface-Einheit 32 der analogen Ausgangsklemme 16 zugeführt und vom Protokollgenerator 50 und dem Steuerrechner bzw. Testautomat 40 ausgewertet.

Entspricht der Prüfsummenwert einem vorgegebenen Summenwert, so ist dies ein Kriterium dafür, dass die digitale Signalverarbeitungseinrichtung 22 korrekt arbeitet und demzufolge insoweit die integrierte Schaltungsanordnung 10 intakt ist. Entspricht dagegen der Prüfsummenwert nicht dem vorgegebenen Sollwert, so ist dies ein Indiz dafür, dass zumindest die digitale Signalverarbeitungseinrichtung 22 der integrierten Schaltungsanordnung 10 defekt ist.

Am Ende des Testmodus sorgt die Ablaufsteuerung 24 dafür, dass die Umschalteinrichtung 28 wieder in die in Figur 1 dargestellte Stellung zurückfällt, also in Normalbetrieb umschaltet. Im Normalbetrieb ist der Pseudozufallsgenerator 26 angehalten.

Bei der in Figur 1 dargestellten Schaltungsanordnung wird vorteilhafterweise ausgenutzt, dass die ohnehin vorhandenen Klemmen 12, 14 und 16 der integrierten Schaltungsanordnung 10 auch im Testmodus verwendet werden. Zusätzliche Anschlusspins speziell für den Testmodus sind also nicht vorgesehen. Schließlich wird vorteilhafterweise auch die ohnehin innerhalb der integrierten Schaltungsanordnung 10 enthaltene Interface-Einheit 32 genutzt.

### Bezugszeichenliste

- 10: integrierte Schaltungsanordnung
- 12: Versorgungsspannungsklemme
- 14: Bezugspotentialklemme
- 16: Ausgangsklemme
- 20: analoger Schaltungsteil
- 20a: Sensor
- 22: digitale Signalverarbeitungseinheit
- 24: Ablaufsteuereinrichtung
- 26: Pseudozufallsgenerator
- 28: Umschalteinrichtung
- 30: Prüfsummenrechenwerk
- 40: Steuerrechner, Testautomat
- 50: Protokollgenerator

## Patentansprüche

1. Verfahren zum Testen einer integrierten Schaltungsanordnung (10), bei welcher der Testvorgang durch Einschalten eines Testmodus ausgelöst wird, bei welchem ein Testablauf durchgeführt und am Ende des Testmodus eine Umschaltung in einen Normalmodus erfolgt, wobei im Testmodus ein Pseudozufallsgenerator (26) innerhalb der integrierten Schaltungsanordnung (10) eine Vielzahl von digitalen Testwerten zur Verfügung stellt, welche jeweils in einer digitalen Signalverarbeitungseinrichtung (22) verarbeitet und jeweils verarbeitet einem Prüfsummenrechenwerk (30) zugeführt werden, und wobei eine im Prüfsummenrechenwerk (30) berechnete Prüfsumme als Kriterium für eine Fehlerfreiheit der integrierten Schaltungsanordnung (10) herangezogen wird, **dadurch gekennzeichnet, daß** zum Auslösen des Testvorganges an eine Versorgungsspannungsklemme (12) der integrierten Schaltungsanordnung (10) ein Startsignal angelegt wird.

2. Verfahren nach Anspruch 1, **dadurch gekennzeichnet, daß** das Prüfsummenrechenwerk (30) mit jedem an einem Ausgang der digitalen Signalverarbeitungseinheit (22) abgreifbaren Wert im Testmodus eine Polynomberechnung durchführt und die einzelnen, bei der Polynomberechnung ermittelten Ergebnisse zu einer Prüfsumme aufaddiert.

3. Integrierte Schaltungsanordnung zur Durchführung des Verfahrens nach Anspruch 1 oder 2 mit einer Ablaufsteuerungseinrichtung (24) zur Steuerung einer Umschalteinrichtung (28), einem Pseudozufallsgenerator (26), einer digitalen Signalverarbeitungseinheit (22) sowie einem zwischen den Ausgang der digitalen Signalverarbeitungseinheit (22) und eine Ausgangsklemme (16) der integrierten Schaltungsanordnung (10) geschalteten Prüfsummenrechenwerk (30), wobei durch die Umschalteinrichtung (28) entweder ein Datensignal oder der Pseudozufallsgenerator (26) an die digitale Signalverarbeitungseinheit (22) schaltbar ist, **dadurch gekennzeichnet, dass** das Datensignal von einer analogen Schaltungseinheit (20) bereitgestellt wird, und dass, eine Interface-Einheit (32) vorgesehen ist, welche zwischen eine Versorgungsspannungsklemme (12) und die Ausgangsklemme (16) der integrierten Schaltungsanordnung (10) geschaltet ist und mit der Ablaufsteuereinrichtung (24) und dem Prüfsummenrechenwerk (30) in Verbindung steht.

4. Integrierte Schaltungsanordnung nach Anspruch 3, **dadurch gekennzeichnet, daß** die Ausgangsklemme (16) eine Klemme ist, an der ein analoges Signal der integrierten Schaltungsanordnung (10) abgreifbar ist.

5. Integrierte Schaltungsanordnung nach Anspruch 4, **dadurch gekennzeichnet, daß** diese einen Sensor (20a) aufweist.

6. Integrierte Schaltungsanordnung nach einem der Ansprüche 3 bis 5, **dadurch gekennzeichnet, daß** das Prüfsummenrechenwerk (30) eine Polynomberechnungseinrichtung und eine Addierstufe aufweist.

7. Einrichtung mit der integrierten Schaltungsanordnung nach einem der Ansprüche 3 bis 6 zum Anschluß der integrierten Schaltungsanordnung an einen Steuerrechner oder an einen Testautomaten (40), wobei ein Protokollgenerator (50) einerseits mit der Versorgungsspannungsklemme (12) und der Ausgangsklemme (16) der integrierten Schaltungsanordnung (10) in Verbindung steht und andererseits an den Steuerrechner oder Testautomaten (40) angeschlossen ist.

## Claims

1. A method for testing an integrated circuit configuration (10), in which the test operation is triggered by switching on a test mode during which a test program is performed and at the end of the test mode a switchover into a normal mode takes place, whereby in the test mode a pseudo-random generator (26) inside the integrated circuit configuration (10) makes available a plurality of digital test values, which in each case are processed in a digital signal processing unit (22) and in each case are supplied in processed form to a running digital sum processor (30), and whereby a running digital sum calculated in the running digital sum processor (30) is used as a criterion for accuracy of the integrated circuit configuration (10),
**characterised in that** to trigger the test operation a start signal is applied to a supply voltage terminal (12) of the integrated circuit configuration (10).

2. A method according to Claim 1,
**characterised in that** the running digital sum processor (30) with every value that can be tapped at an output of the digital signal processing unit (22) in the test mode performs a polynomial calculation and adds up the individual results determined during the polynomial calculation to produce a running digital sum.

3. An integrated circuit configuration for performing the method according to Claim 1 or 2, having a program run control unit (24) for controlling a protection switching device (28), a pseudo-random generator (26), a digital processing unit (22) and also a running digital sum processor (30) switched between the output of the digital signal processing unit (22) and an output terminal (16) of the integrated circuit configuration (10), wherein by the protection switching device (28) either a data signal or the pseudo-random generator (26) can be switched to the digital signalling processing unit (22),
**characterised in that** the data signal is made available by an analogue circuit unit (20),
**and in that** an interface unit (32) is provided, which is switched between a supply voltage terminal (12) and the output terminal (16) of the integrated circuit configuration (10) and is connected to the program run control unit (24) and the running digital sum processor (30).

4. An integrated circuit configuration according to Claim 3,
**characterised in that** the output terminal (16) is a terminal at which an analogue signal can be tapped from the integrated circuit configuration (10).

5. An integrated circuit configuration according to Claim 4,
**characterised in that** it comprises a sensor (20a).

6. An integrated circuit configuration according to one of Claims 3 to 5,
**characterised in that** the running digital sum processor (30) comprises a polynomial calculation device and an adding stage.

7. An appliance with the integrated circuit configuration according to one of Claims 3 to 6 for connection of the integrated circuit configuration to a control computer or to an automatic tester (40), wherein a protocol generator (50) firstly communicates with the supply voltage terminal (12) and the output terminal (16) of the integrated circuit configuration (10) and secondly is connected to the control computer or automatic tester (40).

## Revendications

1. Procédé pour tester un circuit intégré (10) dans lequel l'opération de test est déclenchée en lançant un mode de test, selon lequel
on exécute le test et à la fin du mode de test on passe à un mode normal, en mode de test un générateur pseudoaléatoire (26) fournit à l'intérieur du circuit intégré (10) un grand nombre de valeurs numériques chacune traitées dans une unité numérique de traitement des signaux (22) et, une fois traitées, elles sont acheminées à une unité arithmétique à total de contrôle (30) et
un total de contrôle calculé dans l'unité arithmétique à total de contrôle (30) est un critère que le circuit intégré (10) n'est pas défectueux,
**caractérisé en ce que**
pour déclencher l'opération de test un signal de démarrage est appliqué à une borne de tension d'alimentation (12) du circuit intégré (10).

2. Procédé selon la revendication 1,
**caractérisé en ce qu'**
en mode de test, l'unité arithmétique à total de contrôle (30) calcule un polynôme à l'aide de chaque valeur qu'on peut prélever à une sortie de l'unité numérique de traitement des signaux (22) et, pour obtenir un total de contrôle, elle additionne chacun des résultats établis lors du calcul de polynôme.

3. Circuit intégré pour exécuter le procédé d'après la revendication 1 ou 2 comportant :
- une installation de commande séquentielle (24) pour commander une installation de basculement (28),
- un générateur pseudoaléatoire (26),
- une unité numérique de traitement des signaux (22), et
- une unité arithmétique à total de contrôle (30) montée entre la sortie de l'unité numérique de traitement des signaux (22) et une borne de sortie (16) du circuit intégré (10),
dans lequel l'installation de basculement (28) commute, sur l'unité numérique de traitement des signaux (22), soit un signal de données soit le générateur pseudoaléatoire (26),
**caractérisé en ce que**
le signal de données est fourni par une unité analogique de circuit (20) et
une unité d'interface (32) est montée entre une borne de tension d'alimentation (12) et la borne de sortie (16) du circuit intégré (10) et est en liaison avec l'installation de commande séquentielle (24) et avec l'unité arithmétique à total de contrôle (30).

4. Circuit intégré selon la revendication 3,
**caractérisé en ce que**
la borne de sortie (16) est une borne sur laquelle il est possible de prélever un signal analogique du circuit intégré (10).

5. Circuit intégré selon la revendication 4,
**caractérisé en ce qu'**
il comporte un capteur (20a).

6. Circuit intégré selon l'une des revendications 3 à 5,
**caractérisé en ce que**
l'unité arithmétique à total de contrôle (30) comporte une étape d'addition et une installation pour calculer des polynômes.

7. Installation équipée du circuit intégré selon l'une des revendications 3 à 6 destinée à raccorder le circuit intégré à un ordinateur de commande ou à un appareil de test (40),
dans laquelle un générateur de protocoles (50) d'une part est relié à la borne de tension d'alimentation (12) et à la borne de sortie (16) du circuit intégré (10) et d'autre part est raccordé à l'ordinateur de commande ou à l'appareil de test (40).
